(19) 【Europäisches Patentamt / European Patent Office / Office européen des brevets】

(11) **EP 4 586 446 A1**

(12) **EUROPEAN PATENT APPLICATION**
published in accordance with Art. 153(4) EPC

(43) Date of publication:
**16.07.2025 Bulletin 2025/29**

(21) Application number: **23862917.4**

(22) Date of filing: **21.08.2023**

(51) International Patent Classification (IPC):
*H02J 7/00* (2006.01)   *G01R 31/382* (2019.01)
*H01M 10/48* (2006.01)   *H02J 7/04* (2006.01)
*H02J 7/10* (2006.01)

(52) Cooperative Patent Classification (CPC):
**G01R 31/382; H01M 10/48; H02J 7/00; H02J 7/04;**
**H02J 7/06;** Y02E 60/10

(86) International application number:
**PCT/JP2023/030009**

(87) International publication number:
**WO 2024/053378 (14.03.2024 Gazette 2024/11)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **09.09.2022 JP 2022143579**

(71) Applicant: **Panasonic Intellectual Property**
**Management Co., Ltd.**
**Kadoma-shi, Osaka 571-0057 (JP)**

(72) Inventors:
• **NISHIKAWA, Shinya**
**Kadoma-shi, Osaka 571-0057 (JP)**
• **TAKEDA, Mutsuhiko**
**Kadoma-shi, Osaka 571-0057 (JP)**
• **ITAKURA, Yusuke**
**Kadoma-shi, Osaka 571-0057 (JP)**

(74) Representative: **Novagraaf International SA**
**Chemin de l'Echo 3**
**1213 Onex, Geneva (CH)**

(54) **CHARGING CONTROL SYSTEM, CHARGING CONTROL METHOD AND CHARGING CONTROL PROGRAM, AND STORAGE MEDIUM ON WHICH CHARGING CONTROL PROGRAM IS WRITTEN**

(57)    An acquisition unit of a charging control system acquires battery data including at least one of a current flowing through a battery and a temperature of the battery when the battery is charged. A detector thereof detects an abnormal phenomenon of the battery based on at least one of a behavior of the current and a behavior of the temperature when the battery is charged. A charging current changer thereof changes a current rate when the battery is charged next time to a value obtained by multiplying $\alpha$ ($0 < a < 1$) by the current rate when the abnormal phenomenon of the battery is detected.

EP 4 586 446 A1

# FIG. 10

Start

S10 — Acquire battery data after end of charging

S11 — Internal short-circuit event is detected during CC charging period? — N

Y

S12 — Store SOC when internal short-circuit event is detected

S13 — Current rate = current rate × 0.9

S14 — Current rate < lower limit value ? — N

Y

S15 — Set charging prohibition of target battery pack

S16 — Current rate = current rate × 1.05

S17 — Current rate > default current rate ? — N

Y

S18 — Current rate = default current rate

End

2

**Description**

TECHNICAL FIELD

The present disclosure relates to a charging control system, a charging control method, and a charging control program for managing a current rate when a battery pack is charged.

BACKGROUND ART

In recent years, lithium ion batteries have been used for various applications. The lithium ion batteries uniformly perform control of prohibiting use of a lithium ion battery cell or a battery pack (including a plurality of lithium battery cells) in many cases when an abnormality caused by lithium deposition is detected. Prohibiting the use of cells or packs prevents unsafe events such as ignition. For example, Patent Literature 1 discloses a control method for determining that a battery is unchargeable and stopping charging when a detected battery voltage is less than a first voltage.

Citation List

Patent Literature

PTL 1: Unexamined Japanese Patent Publication No. 2009-254215

SUMMARY OF THE INVENTION

Unfortunately, the method for determining whether there is abnormality of a battery using a threshold for abnormality determination and prohibiting use of the battery when the abnormality is detected has the following problems. When the threshold value for abnormality determination is set to a loose value, even a battery having a slight abnormality is continuously used, and thus lithium deposition may be accelerated during that time to shorten the life of the battery. In contrast, when the threshold value for abnormality determination is set to a strict value, even a battery that can still be safely used depending on usage becomes unusable to deteriorate cost performance of the battery as a product.

The present disclosure has been made in view of such a situation, and an object thereof is to provide a technique for suppressing a deterioration in cost performance of a battery while ensuring safety.

To solve the above problem, a charging control system according to an aspect of the present disclosure includes: an acquisition unit that acquires battery data including at least one of a current flowing through a battery and a temperature of the battery when the battery is charged; a detector that detects an abnormal phenomenon of the battery based on at least one of a behavior of the current and a behavior of the temperature when the battery is charged; and a charging current changer that changes a current rate when the battery is charged next time to a value acquired by multiplying $\alpha$ ($0 < \alpha < 1$) by the current rate when the abnormal phenomenon of the battery is detected.

Any combinations of configuration elements described above and expressions of the present disclosure that are converted in terms of devices, systems, methods, computer programs, recording media, and the like are also effective as aspects of the present disclosure.

The present disclosure enables suppressing a deterioration in cost performance of a battery while ensuring safety.

BRIEF DESCRIPTION OF THE DRAWINGS

Fig. 1 is a diagram illustrating a schematic configuration of a battery exchange station in which a charging control system according to an exemplary embodiment is used.
Fig. 2 illustrates a configuration example of the charging control system according to the exemplary embodiment.
Fig. 3 is a diagram illustrating an example of transition of a voltage, a current, and a temperature of a cell in which an internal short circuit event occurs during CCCV charging.
Fig. 4 is a diagram illustrating an equivalent circuit model of a cell in which phenomenon 1 has occurred.
Fig. 5 is a diagram illustrating a negative electrode model for describing phenomena 3 to 4.
Fig. 6 is a diagram illustrating an equivalent circuit model of a cell after phenomenon 4 occurs.
Fig. 7 is a diagram illustrating an equivalent circuit model of a cell after phenomenon 5 occurs.
Fig. 8 is a diagram showing an example of a relationship among a potential of a positive electrode, a potential of a negative electrode, and an SOC of a cell.
Fig. 9 is a diagram illustrating a cell model for describing phenomena 7 to 10.
Fig. 10 is a flowchart illustrating a specific example of update processing of a current rate performed by the charging control system according to the exemplary embodiment.
Fig. 11 is a flowchart illustrating a specific example of update processing of a voltage value used in a CV charging period, the update processing being performed by the charging control system according to the exemplary embodiment.

DESCRIPTION OF EMBODIMENT

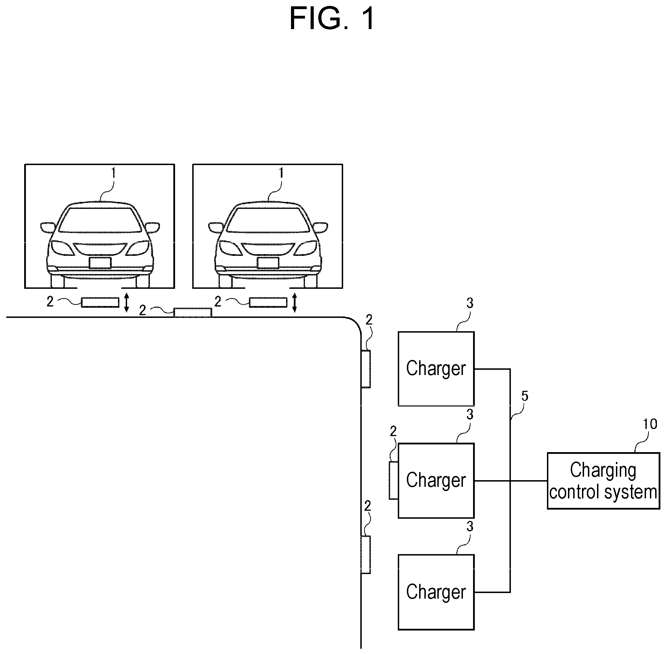

Fig. 1 is a diagram illustrating a schematic configuration of a battery exchange station in which charging control system 10 according to an exemplary embodiment is used. The battery exchange station is installed at a business base of a delivery company or a taxi company, for example. The company manages and operates a plurality of electric vehicles 1, a plurality of battery packs 2, and a plurality of chargers 3 at the business base. The plurality of battery packs 2 are detachable and replaceable battery packs, and are prepared more in number than electric vehicles 1.

Battery pack 2 is attached to a bottom surface of electric vehicle 1. When electric vehicle 1 is stopped at a predetermined position on a replacement table, a replacement device (not illustrated) installed below the replacement table removes used battery pack 2 from the bottom surface of electric vehicle 1 and attaches charged battery pack 2. The replacement table is provided below with a belt conveyor for conveying battery pack 2. Used battery pack 2 is conveyed to a position of charger 3 by the belt conveyor. Battery pack 2 having been charged by charger 3 is conveyed to a position of each replacement table by the belt conveyor. Electric vehicle 1 can usually replace battery pack 2 in about five minutes, and thus can resume traveling at about the same time as refueling time of a gasoline vehicle.

Each charger 3 includes at least one charging slot, and charges battery pack 2 when battery pack 2 is attached. Charger 3 and battery pack 2 may be connected by a charging cable.

Battery pack 2 includes a plurality of cells and a battery management unit (BMU). The plurality of cells is connected in series in battery pack 2. Alternatively, a plurality of parallel cell blocks may be connected in series, the plurality of parallel cell blocks each including a plurality of cells connected in parallel. Available examples of the cell include a lithium ion battery cell, a nickel metal hydride battery cell, and a lead battery cell. Hereinafter, the present description assumes an example of use of lithium ion battery cells (nominal voltage: 3.6 V to 3.7 V). The number of cells or parallel cell blocks in series is determined in accordance with a drive voltage of a motor mounted on electric vehicle 1.

The battery management unit monitors and measures voltage, current, temperature, and state of charge (SOC) of the plurality of cells or the plurality of parallel cell blocks included in battery pack 2. The plurality of cells or the plurality of parallel cell blocks connected in series is connected to a shunt resistor in series. The shunt resistor functions as a current detection element. Instead of the shunt resistor, a Hall element may be used. Battery pack 2 internally includes a plurality of temperature sensors (e.g., a thermistor) installed to detect temperature of the plurality of cells or the plurality of parallel cell blocks. One temperature sensor may be provided per six to eight cells or per one parallel cell block, for example.

The battery management unit estimates the SOC by a combination of an open circuit voltage (OCV) method and a current integration method. The OCV method is configured to estimate the SOC based on the OCV of each measured cell and an SOC-OCV curve of the cell. The current integration method is configured to estimate the SOC based on the OCV at the start of charging and discharging of each cell and an integrated value of a measured current. The current integration method causes a measurement error of the current to accumulate as charging and discharging time increases. Thus, the SOC estimated by the OCV method is preferably corrected using the SOC estimated by the current integration method.

The battery management unit periodically (e.g., an interval of ten seconds) samples voltage, current, temperature, and SOC of the plurality of cells or the plurality of parallel cell blocks, and accumulates the sampled voltage, current, temperature, and SOC as battery data on battery pack 2. The battery management unit may record two of the maximum temperature and the minimum temperature among a plurality of temperatures detected by a plurality of temperature sensors installed in battery pack 2.

Charger 3 is connected to a commercial power system (not illustrated) to charge battery pack 2. In general, AC is used for normal charging, and DC is used for quick charging. When AC (e.g., single-phase 100/200V) is used for charging, AC power is converted into DC power by an AC/DC converter in battery pack 2. When DC is used for charging, charger 3 generates DC power by performing full-wave rectifying of AC power supplied from the commercial power system, and by smoothing the rectified AC power by a filter.

Available examples of quick charging standards include CHAdeMO (registered trademark), ChaoJi, and GB/T, and combined charging system (Combo). CHAdeMO 2.0 defines maximum power output (specification) as 1000 V × 400 A = 400 kW. CHAdeMO 3.0 defines maximum power output (specification) as 1500 V × 600 A = 900 kW. ChaoJi defines maximum power output (specification) as 1500 V × 600 A = 900 kW. GB/T defines maximum power output (specification) as 750 V × 250 A = 185 kW. Combo defines maximum power output (specification) as 900 V × 400 A = 350 kW. CHAdeMO, ChaoJi, and GB/T each use a controller area network (CAN) as a standard communication method. Combo uses power line communication (PLC) as a standard communication method.

Charger 3 supporting rapid charging includes a DC/DC converter. During the rapid charging, the DC/DC converter of charger 3 controls a charging current or a charging voltage during charging. In the present exemplary embodiment, charger 3 charges battery pack 2 by a constant current and constant voltage (referred to below as CCCV) method. The CCCV method is configured such that CC charging of battery pack 2 is started at a set current rate, and when voltage of battery pack 2 reaches a set target voltage, control is switched to control of performing CV charging of battery pack 2 at the target voltage. In the present embodiment, the current rate used for a CC charging period and a value of the voltage used for a CV charging period are designated from charging control system 10.

For normal charging, the AC/DC converter or the DC/DC converter of battery pack 2 controls a charging current or a charging voltage during charging. This control causes charging control system 10 to notify the battery management unit of battery pack 2 of the current rate used in the CC charging period and the value of the voltage used for the CV charging period through charger 3. The battery management unit of battery pack 2 transmits battery data during the charging to charger 3. Charger 3 transmits the received battery data to charging control system 10.

Charging control system 10 is configured to perform charging control of the plurality of battery packs 2 managed by a company operating the battery exchange station. Charging control system 10 may be constructed on a server or a PC installed at a business base where the battery exchange station is installed, for example. Charging control system 10 may be also constructed on an own server installed in an own facility or a data center of a company providing a battery analysis service to a plurality of companies. Additionally, charging control system 10 may be constructed on a cloud server used by a delivery company, a taxi company, or a battery analysis company based on a cloud service contract. Charging control system 10 may be also constructed on a plurality of servers dispersedly installed in a plurality of bases (data center, own facility). The plurality of servers may be a combination of a plurality of own servers, a combination of a plurality of cloud servers, or a combination of own servers and cloud servers.

Charging control system 10 and the plurality of chargers 3 installed in the battery exchange station are connected through network 5 (e.g., a wired/wireless LAN, the Internet, a dedicated line, a virtual private network (VPN), or the like). Each charger 3 transmits battery data acquired from battery pack 2 to charging control system 10 through network 5.

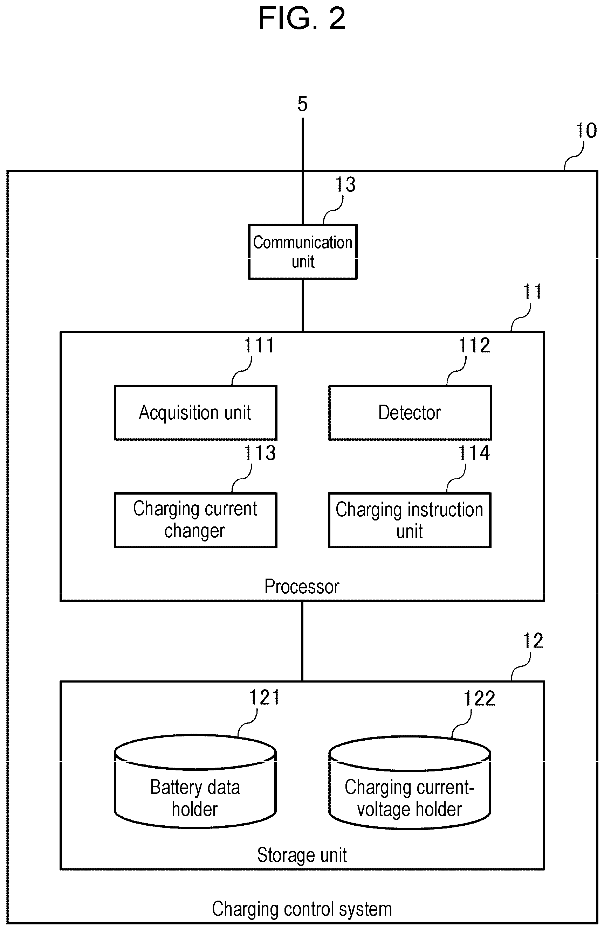

Fig. 2 illustrates a configuration example of charging control system 10 according to the exemplary embodiment. Charging control system 10 includes processor 11, storage unit 12, and communication unit 13. Communication unit 13 is a communication interface (e.g. NIC: Network Interface Card) for connection to network 5 in a wired or wireless manner.

Processor 11 includes acquisition unit 111, detector 112, charging current changer 113, and charging instruction unit 114. Functions of processor 11 can be achieved by cooperation of a hardware resource and a software resource, or by the hardware resource alone. Available examples of the hardware resource include a CPU, a ROM, a RAM, a graphics processing unit (GPU), an application specific integrated circuit (ASIC), a field programmable gate array (FPGA), and other LSI circuits. Available examples of the software resource include a program, such as an operating system or an application. Although the program is here recorded in advance in a memory of storage unit 12, the program may be provided through a telecommunication line such as the Internet or by being recorded in a non-transitory recording medium such as a memory card.

Storage unit 12 includes a non-volatile recording medium such as an HDD or an SSD, and stores various kinds of data. Storage unit 12 includes battery data holder 121 and charging current-voltage holder 122.

Acquisition unit 111 acquires battery data on each battery pack 2 from each charger 3 and stores the acquired battery data in battery data holder 121.

Charging current-voltage holder 122 holds a current rate used for the CC charging period and a voltage value used for the CV charging period during charging for each battery pack 2 managed by the company, the charging being performed by the CCCV method. Battery pack 2 is managed by an ID. For a default of the current rate used for the CC charging period and a default of the voltage value used for the CV charging period, a recommended value published by a battery manufacturer for each type may be used, or a value determined by the company may be used.

The current rate used for the CC charging period is determined in consideration of a balance between charging time and battery degradation within a range of a rated current of battery pack 2. When the charging time is shortened, the current rate needs to be increased, and thus a burden on the battery increases. In contrast, when the charging time is allowed to increase, the current rate can be lowered, and thus the burden on the battery decreases.

The voltage value used for the CV charging period is determined in accordance with capacity of battery pack 2 within a range of a rated voltage of battery pack 2. The voltage value used for the CV charging period may be lowered as a state of health (SOH) of the battery decreases.

Acquisition unit 111 acquires battery data during CCCV charging of battery pack 2 from charger 3. Acquisition unit 111 may acquire the battery data during the CCCV charging from charger 3 in real time, or may acquire the battery data during the CCCV charging period after completion of the charging. The acquired battery data includes the ID of battery pack 2 and also includes at least one of a current flowing through battery pack 2 and temperature of battery pack 2. Acquisition unit 111 stores the acquired battery data in battery data holder 121.

Detector 112 detects an abnormal phenomenon of a cell in battery pack 2 based on at least one of a behavior of a current and a behavior of temperature of battery pack 2 during the CV charging period when battery pack 2 is charged by the CCCV charging. Available examples of the temperature include a maximum temperature detected by a plurality of temperature sensors installed in battery pack 2.

In the present embodiment, attention is paid to a minute internal short circuit event due to lithium deposition as the abnormal phenomenon of a cell in battery pack 2. When the internal short circuit event occurs, a current increases or the current decreases during CV charging, and temperature rises sharply.

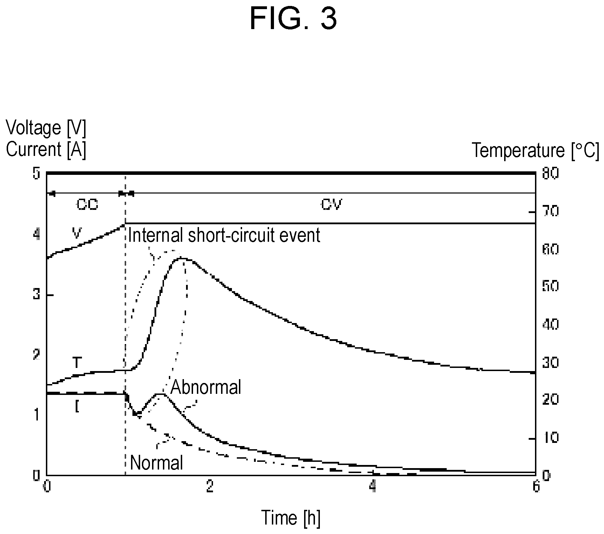

Fig. 3 is a diagram illustrating an example of transition of voltage V, current I, and temperature T of the cell in which the internal short circuit event occurs during the CCCV charging. When the cell is in a normal state, current I gradually decreases during the CV charging period. In contrast, when the internal short circuit event occurs in the cell during the CV charging period, current I increases. Consequently, temperature T of the cell rapidly rises. The transition of voltage V, current I, and temperature T illustrated in Fig. 3 is an example, and thus a degree of change in the current or the temperature varies depending on an internal state of the cell. For example, current I may decrease at a low speed instead of increasing.

Next, a mechanism of occurrence of the internal short circuit event will be described. When charging and discharging with a short rest time is repeated, phenomena 1 to 4 below occur. Examples of the short rest time include a rest time of about 20 minutes.

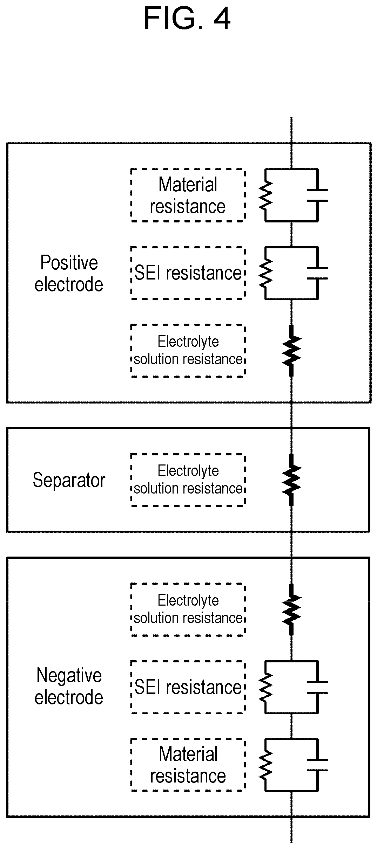

Fig. 4 is a diagram illustrating an equivalent circuit model of a cell in which phenomenon 1 has occurred. When charging and discharging with a short rest time is repeated, return of an electrolyte solution is delayed, and thus the electrolyte solution is depleted to cause increase in liquid resistance (phenomenon 1). The increase in liquid resistance causes decrease in current. The increase in liquid resistance also reduces a potential of a negative electrode (phenomenon 2).

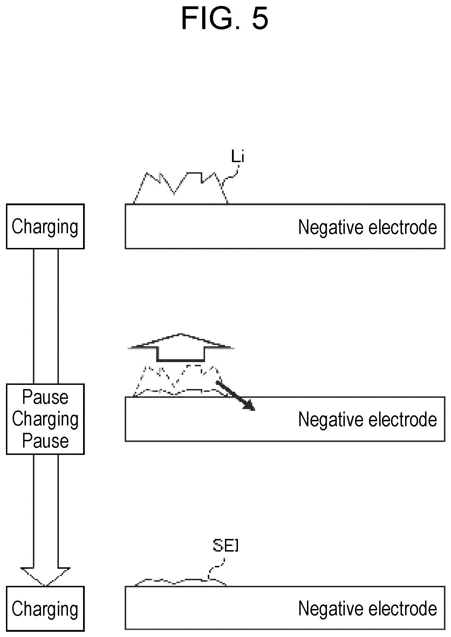

Fig. 5 is a diagram illustrating a negative electrode model for describing phenomena 3 to 4. At an end stage of charging, a potential of a negative electrode falls below a lithium potential, and a small amount of lithium is deposited on the negative electrode (phenomenon 3). The lithium deposited on the negative electrode is inserted into the negative electrode during a rest and returns to a positive electrode during discharge. The lithium deposited mostly returns to the positive electrode during the discharge, but partially remains on the negative electrode. The lithium remaining on the negative electrode reacts with the electrolyte solution at every charging and discharging to change to solid electrolyte interphase (SEI) (phenomenon 4). The SEI grows by repeating this kind of process. The growth of the SEI leads to an increase in resistance to cause a decrease in current.

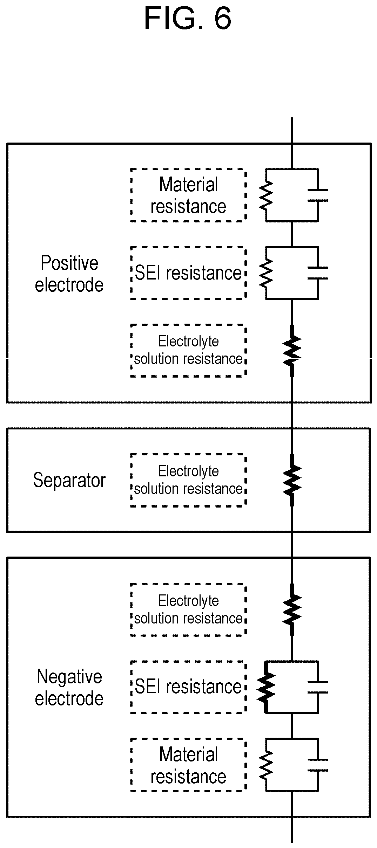

Fig. 6 is a diagram illustrating an equivalent circuit model of a cell after phenomenon 4 occurs. In the cell after phenomenon 4 occurs, SEI resistance of the negative electrode increases.

When a long rest time is interposed between charging and discharging, phenomena 5 and 6 below occur. Examples of the long rest time include a rest time of about one hour. The long rest time causes the electrolyte solution to return to the positive electrode (phenomenon 5).

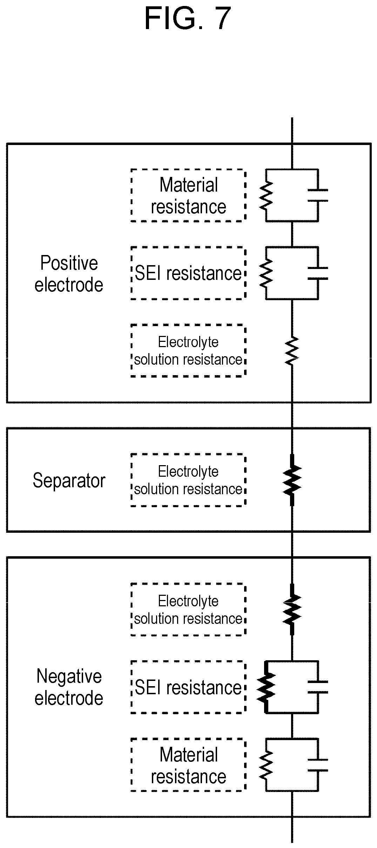

Fig. 7 is a diagram illustrating an equivalent circuit model of a cell after phenomenon 5 occurs. In the cell after phenomenon 5 occurs, solution resistance of the positive electrode decreases. When a potential of the positive electrode decreases as internal resistance of the positive electrode decreases, a potential of the negative electrode further decreases to maintain target voltage (e.g., 4.2 V) during CV charging (phenomenon 6).

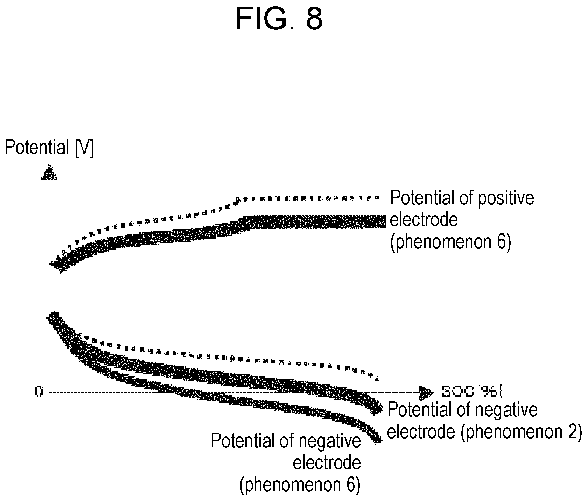

Fig. 8 is a diagram showing an example of a relationship among a potential of a positive electrode I, a potential of a negative electrode, and an SOC of a cell. The horizontal axis represents the SOC, and the vertical axis represents the potential of the positive electrode and the potential of the negative electrode. The potential of the positive electrode increases as the SOC increases, and the potential of the negative electrode decreases as the SOC increases. As described above, increase in solution resistance due to shortage of the electrolyte solution causes the potential of the negative electrode to decrease (phenomenon 2). As the solution resistance of the positive electrode decreases, the potential of the positive electrode and the potential of the negative electrode decrease to a similar extent (phenomenon 6). This state causes lithium to be likely to be deposited, and increases a current.

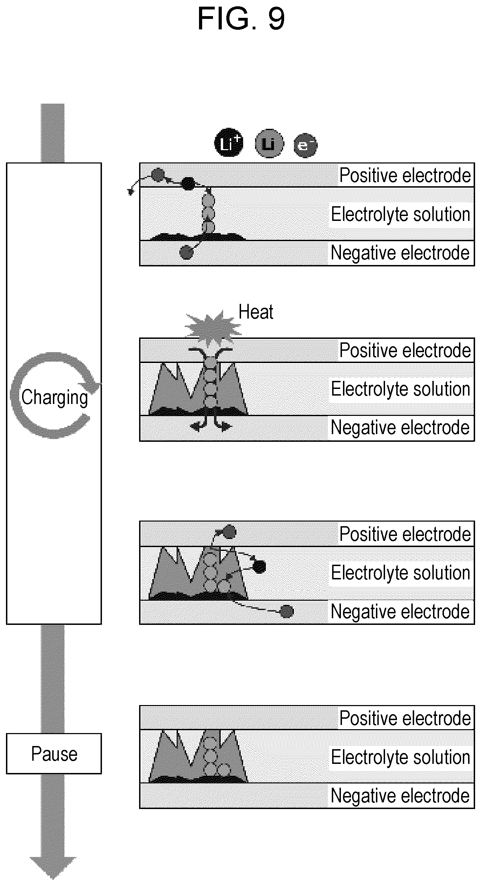

Fig. 9 is a diagram illustrating a cell model for describing phenomena 7 to 10. Charging causes phenomena 7 to 9 below to repeatedly occur, so that an internal short circuit event occurs. The potential of the negative electrode greatly decreases and the current increases, so that a large amount of lithium is deposited on the SEI (phenomenon 7). The amount of deposition of lithium is more than that in phenomenon 3.

The positive electrode and the negative electrode are short-circuited by the lithium having deposited, so that a short-circuit current flows to generate heat (phenomenon 8). The lithium in contact with the positive electrode is oxidized to form lithium ions. Lithium ions deposit on the negative electrode, and the short circuit disappears (phenomenon 9). When charge is stopped, lithium deposition stops, and thus heat generation due to short circuit stops (phenomenon 10).

To detect the internal short circuit event described above from the outside, it is conceivable to detect at least one of an increase in current during CV charging and a rapid temperature rise during CV charging. When a micro-short circuit occurs in a cell, a current increases because a converter operates to maintain a target voltage for CV charging. The micro-short circuit causes the entire cell to uniformly generate heat.

Factors that hinder detection of the internal short-circuit event include the following.

(a) For an internal short circuit at a mild level, a current decreases in reduction speed without increasing in amount.
(b) For CV charging performed with respect to total voltage, a current does not increase in amount when an internal short-circuit event occurs.

(c) During CV charging, charging returns to CC charging again. In this state, a current increases in amount even when no internal short circuit event occurs.

(d) During CV charging, current hunting occurs.

(e) Battery temperature rapidly rises due to heating with an external heat source (e.g., a heater).

(f) Cooling with a cooler suppresses an increase in battery temperature.

Hereinafter, a highly reliable method for detecting an internal short-circuit event will be described. During the CV charging period of battery pack 2, detector 112 detects an internal short-circuit event by detecting a temperature rise of a cell, the temperature rise exceeding a calorific value generated by a charging current. More specifically, during the CV charging period, detector 112 detects the internal short-circuit event of the cell in battery pack 2 by comparing a ratio between the integrated amount of current flowing through the cell in battery pack 2 during a fixed period and the temperature rise of the cell in battery pack 2 in the fixed period with a fixed threshold.

Calorific value Q generated by a charging current is acquired by Expression (1) below.

$$Q = I^2 \times R \times \Delta t \ ... \ (Expression \ 1)$$

where Q is calorific value [J],
$\Delta t$ is time required for temperature rise of $\Delta T$ [s],
I is average current [A] during $\Delta t$ period, and
R is internal resistance [$\Omega$].

Calorific value Q of a cell estimated from temperature measured by a temperature sensor is acquired by Expression below (Expression 2).

$$Q = C \times \Delta T \ ... \ (Expression \ 2)$$

where Q is calorific value [J],
C is heat capacity of cell [J/K], and
$\Delta T$ is temperature increased during $\Delta t$ period [°C].

Detector 112 determines that an internal short-circuit event occurs in a cell in battery pack 2 when a determination score acquired by ($\Delta T / I^2 \times \Delta t$) exceeds a fixed threshold. The fixed threshold is set in advance based on results of experiments and simulations.

When detecting the internal short-circuit event in a cell in battery pack 2 in the CCCV charging at present, detector 112 specifies a SOC of battery pack 2 at the time when the internal short-circuit event is detected. Detector 112 stores the detected SOC in charging current-voltage holder 122.

When the internal short-circuit event is detected in the cell in battery pack 2 in the CCCV charging at present, charging current changer 113 changes a current rate used in the CC charging period when battery pack 2 is charged by the CCCV charging next time to a value acquired by multiplying $\alpha$ ($0 < \alpha < 1$) by the current rate. That is, charging current changer 113 reduces the current rate in the CC charging period at the time of the next charging by a fixed ratio. The current rate has a lower limit having been set. For example, the lower limit is set to a range of 0.1 to 0.5 times a preset default current rate. As the current rate decreases, charging time increases. In view of an operation status of battery pack 2, the company can set or change the lower limit of the current rate to an appropriate value. Charging current changer 113 stores the changed current rate in charging current-voltage holder 122.

The changed current rate is used as a current rate after an SOC of battery pack 2 reaches the SOC at the time when the internal short-circuit event is detected, the current rate being used when battery pack 2 is charged by the CCCV charging next time. Before reaching the SOC, a default current rate is used.

When the internal short-circuit event is not detected in the cell in battery pack 2 in the CCCV charging at present, charging current changer 113 changes a current rate used in the CC charging period when battery pack 2 is charged by the CCCV charging next time to a value acquired by multiplying $\beta$ ($1 < \beta < (2-\alpha)$) by the current rate. That is, charging current changer 113 increases the current rate in the CC charging period at the time of the next charging by a fixed ratio. Charging current changer 113 increases the current rate when the internal short-circuit event is not detected at a ratio smaller than the ratio reduced when the internal short-circuit event is detected. The current rate has an upper limit that is set to a default current rate. Charging current changer 113 stores the changed current rate in charging current-voltage holder 122.

Charging current changer 113 may reduce ratio $\alpha$ used when reducing the current rate as a determination score calculated by detector 112 increases to more than the threshold. For example, charging current changer 113 sets $\alpha$ to a value closer to 0.50 within a range of 0.99 to 0.50 as the determination score increases to more than the threshold. The determination score and "$\alpha$" have a relationship defined by a map or a function. The relationship between the determination score and "$\alpha$" may be set linearly or non-linearly. A relationship among a rate of temperature rise, a current rate, and "$\alpha$" may be defined in a map in advance, and charging current changer 113 may determine the ratio $\alpha$ with reference to the map based on the rate of temperature rise and the current rate at present. For example, a value of "$\alpha$" is defined to be smaller as the rate of temperature rise is higher. Similarly for the ratio $\beta$, a relationship among a rate of temperature rise, a current rate, and "$\beta$" may be defined in a map in advance, and charging current changer 113 may determine the ratio $\beta$ with reference to the map based on the rate of temperature rise and the current rate. For example, as the rate of temperature rise decrease, a larger value is defined as "β".

When charger 3 charges battery pack 2, acquisition unit 111 acquires a pack ID of battery pack 2, which is to be charged, from charger 3. Charging instruction unit 114 refers to charging current-voltage holder 122 based on the acquired pack ID to acquire charging information on battery pack 2 to be charged.

The charging information includes a default current rate used for the CC charging period of battery pack 2 to be charged, an SOC in which the default current rate is switched to a limited current rate, a current rate after limitation, and a voltage value used for the CV charging period. Charging instruction unit 114 notifies charger 3 of a charging instruction including the charging information.

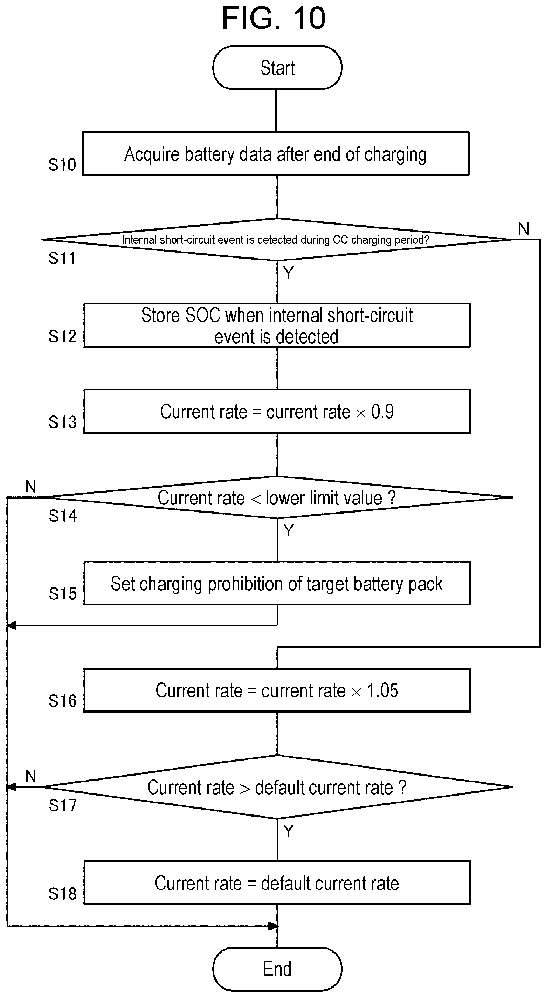

Fig. 10 is a flowchart illustrating a specific example of update processing of a current rate performed by charging control system 10 according to the exemplary embodiment. Acquisition unit 111 acquires battery data during the CCCV charging from charger 3 that has charged battery pack 2 by the CCCV charging (S10). Detector 112 determines whether an internal short-circuit event has occurred in a cell in battery pack 2 during the CV charging period based on battery data during the CV charging period (S11).

When the internal short-circuit event is detected (Y in S11), detector 112 specifies an SOC of battery pack 2 at the time when the internal short-circuit event is detected, and stores the SOC in charging current-voltage holder 122 (S12). Charging current changer 113 multiplies the current rate by 0.9, and stores the changed current rate in charging current-voltage holder 122 (S13).

Charging current changer 113 compares the changed current rate with the lower limit value (S14). When the current rate after the change falls below the lower limit value (Y in S14), charging current changer 113 sets charging prohibition of battery pack 2 to be charged (S15), and stores the charging prohibition of this battery pack 2 in charging current-voltage holder 122. After the storage, the update processing of the current rate ends. When the changed current rate does not fall below the lower limit value (N in S14), the update processing of the current rate ends.

When no internal short-circuit event is detected in step S11 (N in S11), charging current changer 113 multiplies the current rate by 1.05 and stores the changed current rate in charging current-voltage holder 122 (S16).

Charging current changer 113 compares the changed current rate with the default current rate (S17). When the changed current rate exceeds the default current rate (Y in S17), charging current changer 113 changes the current rate to the default current rate, and stores the changed current rate in charging current-voltage holder 122 (S18). After the storage, the update processing of the current rate ends. When the changed current rate does not exceed the default current rate (N in S17), the update processing of the current rate ends.

The above description describes charging control for lowering the current rate when the internal short-circuit event is detected. In this regard, when an internal short-circuit event is detected, charging control for lowering the voltage value used for the CV charging period may be performed.

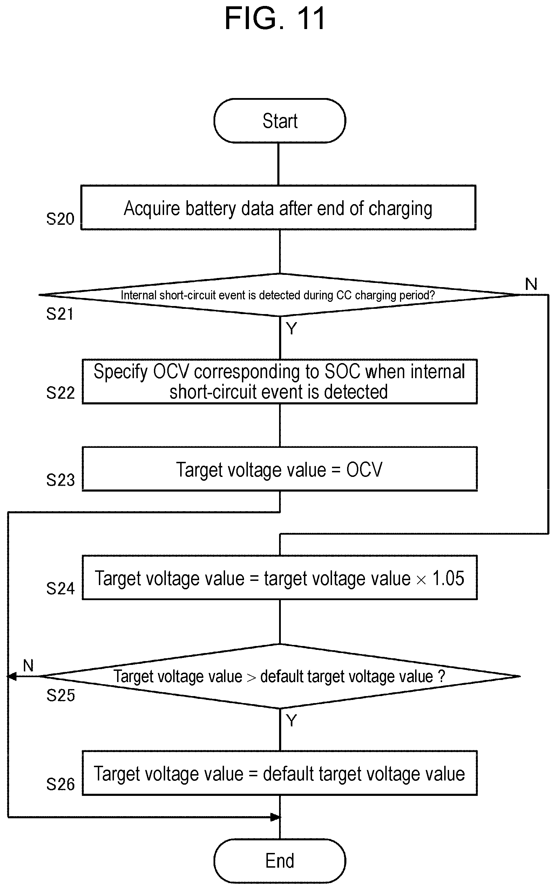

Fig. 11 is a flowchart illustrating a specific example of update processing of the voltage value used for the CV charging period, the update processing being performed by charging control system 10 according to the exemplary embodiment. Acquisition unit 111 acquires battery data during the CCCV charging from charger 3 that has charged battery pack 2 by the CCCV charging (S20). Detector 112 determines whether an internal short-circuit event has occurred in a cell in battery pack 2 during the CV charging period based on battery data during the CV charging period (S21).

When the internal short-circuit event is detected (Y in S21), detector 112 specifies an SOC of battery pack 2 at the time when the internal short-circuit event is detected. Detector 112 refers to the SOC-OCV curve of battery pack 2 based on the specified SOC, and specifies an OCV of battery pack 2 at the time when the internal short-circuit event is detected (S22).

A charging voltage changer (not illustrated) changes the voltage value (referred to below as a target voltage value) used for the CV charging period to the specified OCV, and stores the changed target voltage value in charging current-voltage holder 122. After the storage, the updating processing of the target voltage value ends.

When no internal short-circuit event is detected in step S21 (N in S21), the charging voltage changer multiplies the target voltage value by 1.05 and stores the changed target voltage value in charging current-voltage holder 122 (S24). Multiplying by 1.05 is an example, and the target voltage value may be increased at a ratio other than multiplying by 1.05.

The charging voltage changer compares the changed target voltage value with a default target voltage value (S25). When the changed target voltage value exceeds the default target voltage value (Y in S25), the charging voltage changer changes the target voltage value to the default target voltage value, and stores the changed target voltage value in charging current-voltage holder 122 (S26). After the storage, the updating processing of the target voltage value ends. When the changed target voltage value does not exceed the default target voltage value (N in S25), the updating processing of the target voltage value ends.

In the above description, detector 112 detects the internal short-circuit event based on whether the ratio between the integrated amount of the current flowing through the cell in battery pack 2 during a fixed period and the temperature rise of the cell in battery pack 2 during a fixed period exceeds the threshold during the CV charging period. In this regard, the internal short-circuit event may be simply detected as follows.

Detector 112 may detect the internal short-circuit event based on whether temperature of the cell in battery pack 2 during the CV charging period exceeds a threshold (e.g., 50°C). Detector 112 may also detect the internal short-circuit event based on whether a rate of temperature rise of the cell in battery pack 2 during the CV charging period exceeds a threshold. Alternatively, detector 112 may detect the internal short-circuit event based on whether the current flowing through the cell in the battery pack 2 has increased during a fixed period of time or more during the CV charging period.

As described above, when an abnormality is detected based on battery data, the present embodiment causes the current rate to be lowered by a fixed ratio instead of uniformly prohibiting use of battery pack 2. This configuration enables suppressing a deterioration in cost performance of battery pack 2 while ensuring safety. Battery pack 2 can be continuously used as long as possible while ensuring safety, so that replacement cost of battery pack 2 can be reduced.

Additionally, adding control of returning the current rate when no abnormality is detected in the latest charge enables achieving a balance between safety and product performance. For example, a phenomenon in which temperature rapidly rises due to heat arising from a heater may be erroneously detected as an abnormal phenomenon of a cell. In this situation, the cell itself has no abnormality, so that product performance is impaired by charging with the current rate held at a low value. The product performance can be gradually recovered by returning the current rate while checking safety.

The present embodiment can also address an abnormality in which current or temperature rapidly rises due to factors other than lithium deposition (e.g., foreign matter contamination).

Charging control of lowering the current rate is more advantageous in terms of operation cost than charging control of lowering the target voltage value. The charging control of lowering the current rate does not reduce chargeable capacity, and thus does not cause an increase in the number of times of charging.

The present disclosure has been described above based on the exemplary embodiments. It is to be understood by those skilled in the art that the exemplary embodiments are merely examples, that various modifications can be made by combining each component and each processing process of the exemplary embodiments, and that such modifications are also within the scope of the present disclosure.

When a cell is heated by a heater, it is difficult to determine whether a temperature rise of the cell is due to an increase in charging current or due to heating by the heater. Thus, detection of the internal short-circuit event may be stopped during heating by the heater.

Battery pack 2 of an air-cooling type does not cause temperature of a cell to be lowered in a short time. Thus, when battery pack 2 of an air-cooling type has an unnatural temperature rise during the CV charging, there is a high possibility of an internal short-circuit event. In contrast, when battery pack 2 of a liquid-cooling type has a temperature rise of a cell due to an internal short-circuit event, the temperature rise may be canceled by a cooler of the liquid-cooling type. Battery pack 2 of a liquid-cooling type may correct temperature based on cooling capacity of the cooler to detect an internal short-circuit event using the corrected temperature.

In the above exemplary embodiment, an internal short-circuit event is detected by detecting at least one of an increase in current or a rapid temperature rise during CV charging. In this regard, the internal short-circuit event can also be detected by detecting at least one of an increase in current or a rapid temperature rise during CC charging at a low rate.

In the above exemplary embodiment, an example has been described in which a charging rate of battery pack 2 is managed by charging control system 10 connected to charger 3 through network 5. In this regard, charging control system 10 may be incorporated in a battery management unit (BMU) in battery pack 2. Charging control system 10 may be also incorporated in charger 3.

Charging control system 10 according to the present disclosure is not limited to management of the charging rate of battery pack 2 mounted on electric vehicle 1. For example, charging control system 10 is also applicable to management of a charging rate of a battery pack mounted on an electric ship, a multi-copter (drone), an electric motorcycle, an electric bicycle, a stationary power storage system, a smartphone, a tablet, a notebook PC, or the like.

The exemplary embodiment may be defined by items below.

[Item 1] Charging control system (10) including:

acquisition unit (111) that acquires battery data including at least one of a current flowing through battery (2) and a temperature of battery (2) when battery (2) is charged;

detector (112) that detects an abnormal phenomenon of battery (2) based on at least one of a behavior of the current and a behavior of the temperature when battery (2) is charged; and

charging current changer (113) that changes a current rate when battery (2) is charged next time to a value acquired by multiplying $\alpha$ ($0 < \alpha < 1$) by the current rate when the abnormal phenomenon of battery (2) is detected.

This configuration enables suppressing a deterioration in cost performance of battery pack (2) while ensuring safety.

[Item 2] Charging control system (10) according to item 1, in which when no abnormal phenomenon of battery (2) is detected in the charging at present, charging current changer (113) changes a current rate for next charging of battery (2) to a value acquired by multiplying $\beta$ ($1 < \beta < (2 - \alpha)$) by the current rate.

This configuration enables reduction in extension of unnecessary charging time.

[Item 3] Charging control system (10) according to item 1, in which

detector (112) specifies a state of charge (SOC) of battery (2) at a time when an abnormal phenomenon of battery (2) is detected, and

the changed current rate is used as a current rate after an SOC of battery (2) reaches the SOC at the time when the abnormal phenomenon is detected, the current rate being used when battery (2) is charged next time.

This configuration enables reduction in extension of charging time.

[Item 4] Charging control system (10) according to item 1, in which detector (112) detects an abnormal phenomenon of battery (2) by comparing a ratio between an integrated amount of current flowing through battery (2) during a fixed period and a temperature rise of battery (2) during the fixed period with a fixed threshold during a charging period.

This configuration enables detecting an abnormal phenomenon of battery (2) due to an increase in charging current with high accuracy.

[Item 5] Charging control system (10) according to item 4, in which charging current changer (113) reduces the $\alpha$ as the ratio increases to larger than the threshold.

This configuration enables a lowering rate of the current rate to be optimized.

[Item 6] Charging control system (10) according to item 2, in which charging current changer (113) sets $\beta$ based on a rate of temperature rise of battery (2) and a current rate at present.

This configuration enables a rising rate of the current rate to be optimized.

[Item 7] A charging control method including the steps of:

acquiring battery data including at least one of a current flowing through battery (2) and a temperature of battery (2) when battery (2) is charged;

detecting an abnormal phenomenon of battery (2) based on at least one of a behavior of the current and a behavior of the temperature when battery (2) is charged; and

changing a current rate when battery (2) is charged next time to a value obtained by multiplying $\alpha$ ($0 < \alpha < 1$) by the current rate when the abnormal phenomenon of battery (2) is detected.

This configuration enables suppressing a deterioration in cost performance of battery pack (2) while ensuring safety.

[Item 8] Charging control program that causes a computer to execute processing, the processing including the processes of:

acquiring battery data including at least one of a current flowing through battery (2) and a temperature of battery (2) when battery (2) is charged;

detecting an abnormal phenomenon of battery (2) based on at least one of a behavior of the current and a behavior of the temperature when battery (2) is charged; and

changing a current rate when battery (2) is charged next time to a value obtained by multiplying $\alpha$ ($0 < \alpha < 1$) by the current rate when the abnormal phenomenon of battery (2) is detected.

This configuration enables suppressing a deterioration in cost performance of battery pack (2) while ensuring safety.

REFERENCE MARKS IN THE DRAWINGS

| | |
|---|---|
| 1 | electric vehicle |
| 2 | battery pack |
| 3 | charger |
| 5 | network |
| 10 | charging control system |
| 11 | processor |
| 111 | acquisition unit |
| 112 | detector |
| 113 | charging current changer |
| 114 | charging instruction unit |
| 12 | storage unit |
| 121 | battery data holder |
| 122 | charging current-voltage holder |
| 13 | communication unit |

**Claims**

1. A charging control system comprising:

an acquisition unit that acquires battery data including at least one of a current flowing through a battery or a temperature of the battery when the battery is charged;

a detector that detects an abnormal phenomenon of the battery based on at least one of a behavior of the current or a behavior of the temperature when the battery is charged; and

a charging current changer that changes a current rate when for next charging of the battery to a value obtained by multiplying $\alpha$ by the current rate when the abnormal phenomenon of the battery is detected, where $\alpha$ satisfies $0 < \alpha < 1$.

2. The charging control system according to Claim 1, wherein when no abnormal phenomenon of the battery is detected in the charging at present, the charging current changer changes a current rate for next charging of the battery to a value acquired by multiplying $\beta$ by the current rate, where $\beta$ satisfies $1 < \beta < (2 - \alpha)$.

3. The charging control system according to Claim 1, wherein

the detector specifies a state of charge (SOC) of the battery at a time when an abnormal phenomenon of the battery is detected, and
the changed current rate is used as a current rate after an SOC of the battery reaches the SOC at the time when the abnormal phenomenon is detected, the current rate being used when the battery is charged next time.

4. The charging control system according to Claim 1, wherein the detector detects an abnormal phenomenon of the battery by comparing a ratio between an integrated amount of current flowing through the battery during a fixed period and a temperature rise of the battery during the fixed period with a fixed threshold during a charging period.

5. The charging control system according to Claim 4, wherein the charging current changer reduces the $\alpha$ as the ratio increases to be larger than the threshold.

6. The charging control system according to Claim 2, wherein the charging current changer sets $\beta$ based on a rate of temperature rise of the battery and a current rate at present.

7. A charging control method comprising the steps of:

acquiring battery data including at least one of a current flowing through a battery or a temperature of the battery when the battery is charged;
detecting an abnormal phenomenon of the battery based on at least one of a behavior of the current and a behavior of the temperature when the battery is charged; and
changing a current rate when the battery is charged next time to a value obtained by multiplying $\alpha$ by the current rate when the abnormal phenomenon of the battery is detected, where $\alpha$ satisfies $0 < \alpha < 1$.

8. A charging control program that causes a computer to execute processing, the processing comprising the processes of:

acquiring battery data including at least one of a current flowing through a battery or a temperature of the battery when the battery is charged;
detecting an abnormal phenomenon of the battery based on at least one of a behavior of the current and a behavior of the temperature when the battery is charged; and
changing a current rate when the battery is charged next time to a value obtained by multiplying $\alpha$ by the current rate when the abnormal phenomenon of the battery is detected, where $\alpha$ satisfies $0 < \alpha < 1$.

9. A non-transitory recording medium on which the charging control program according to Claim 8 is described.

# FIG. 1

# FIG. 2

Charging control system (10)

5

Communication unit (13)

Processor (11)
- Acquisition unit (111)
- Detector (112)
- Charging current changer (113)
- Charging instruction unit (114)

Storage unit (12)
- Battery data holder (121)
- Charging current-voltage holder (122)

# FIG. 3

# FIG. 4

# FIG. 5

Charging

Pause
Charging
Pause

Charging

Li

Negative electrode

Negative electrode

SEI

Negative electrode

# FIG. 6

# FIG. 7

# FIG. 8

# FIG. 9

# FIG. 10

```
                    ┌──────────┐
                    │  Start   │
                    └──────────┘
                         │
        ┌────────────────────────────────────────┐
  S10   │  Acquire battery data after end of charging │
        └────────────────────────────────────────┘
```

S10 — Acquire battery data after end of charging

S11 — Internal short-circuit event is detected during CC charging period?  — N

S12 — Store SOC when internal short-circuit event is detected

S13 — Current rate = current rate × 0.9

S14 — Current rate < lower limit value ?  — N

S15 — Set charging prohibition of target battery pack

S16 — Current rate = current rate × 1.05

S17 — Current rate > default current rate ?  — N

S18 — Current rate = default current rate

End

# FIG. 11

```
                          ┌─────────┐
                          │  Start  │
                          └─────────┘
                               │
       ┌───────────────────────────────────────────────┐
  S20  │     Acquire battery data after end of charging │
       └───────────────────────────────────────────────┘
                               │
                               │                              N
           ◇────────────────────────────────────────────────◇──┐
  S21      Internal short-circuit event is detected during CC charging period?
                               │Y                                │
                               │                                 │
       ┌───────────────────────────────────────────────┐        │
  S22  │  Specify OCV corresponding to SOC when internal│        │
       │         short-circuit event is detected        │        │
       └───────────────────────────────────────────────┘        │
                               │                                 │
       ┌───────────────────────────────────────────────┐        │
  S23  │            Target voltage value = OCV          │        │
       └───────────────────────────────────────────────┘        │
                               │                                 │
    ┌──────────────────────────┘                                 │
    │                          ┌──────────────────────────────── ┘
    │                          │
    │  ┌───────────────────────────────────────────────┐
  S24  │   Target voltage value = target voltage value × 1.05 │
    │  └───────────────────────────────────────────────┘
    │                          │
    │  N                       │
    ◇────────────────────────────────────────────────◇
    │  S25   Target voltage value > default target voltage value ?
    │                          │Y
    │      ┌───────────────────────────────────────────────┐
  S26      │  Target voltage value = default target voltage value │
    │      └───────────────────────────────────────────────┘
    │                          │
    └──────────────────────────┤
                               │
                          ┌─────────┐
                          │   End   │
                          └─────────┘
```

## INTERNATIONAL SEARCH REPORT

| International application No. |
| --- |
| **PCT/JP2023/030009** |

**A. CLASSIFICATION OF SUBJECT MATTER**

***H02J 7/00***(2006.01)i; ***G01R 31/382***(2019.01)i; ***H01M 10/48***(2006.01)i; ***H02J 7/04***(2006.01)i; ***H02J 7/10***(2006.01)i
FI: H02J7/00 S; G01R31/382; H01M10/48 P; H01M10/48 301; H02J7/04 L; H02J7/10 H

According to International Patent Classification (IPC) or to both national classification and IPC

**B. FIELDS SEARCHED**

Minimum documentation searched (classification system followed by classification symbols)

H02J7/00; G01R31/382; H01M10/48; H02J7/04; H02J7/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2018/235846 A1 (MURATA MANUFACTURING CO., LTD.) 27 December 2018 (2018-12-27) paragraphs [0025]-[0036], [0070], [0094]-[0095], [0157]-[0159], fig. 1-3 | 1, 7-9 |
| Y | | 1, 7-9 |
| A | | 2-6 |
| Y | JP 2020-523968 A (GUANGDONG OPPO MOBILE TELECOMMUNICATIONS CORP., LTD.) 06 August 2020 (2020-08-06) paragraphs [0122]-[0139], [0145]-[0146], fig. 2, 8, 10 | 1, 7-9 |
| A | | 2-6 |
| Y | JP 2012-115004 A (MITSUMI ELECTRIC CO LTD) 14 June 2012 (2012-06-14) paragraphs [0142]-[0145], fig. 16 | 1, 7-9 |
| Y | JP 09-017458 A (MATSUSHITA ELECTRIC IND CO LTD) 17 January 1997 (1997-01-17) paragraphs [0024], [0031], fig. 7 | 1, 7-9 |
| Y | WO 2022/063234 A1 (BYD COMPANY LIMITED) 31 March 2022 (2022-03-31) paragraph [0065] | 1, 7-9 |

☐ Further documents are listed in the continuation of Box C.　　☑ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 October 2023** | **31 October 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/030009**

| Patent document cited in search report | | | Publication date (day/month/year) | Patent family member(s) | | | Publication date (day/month/year) |
|---|---|---|---|---|---|---|---|
| WO | 2018/235846 | A1 | 27 December 2018 | US | 2020/0350617 | A1 | |
| | | | | paragraphs [0063]-[0074], [0115], [0141]-[0142], [0209]-[0210], fig. 1-3 | | | |
| | | | | CN | 110800151 | A | |
| JP | 2020-523968 | A | 06 August 2020 | US | 2020/0099216 | A1 | |
| | | | | paragraphs [0114]-[0130], [0137]-[0138], fig. 2, 8, 10 | | | |
| | | | | EP | 3657591 | A1 | |
| | | | | CN | 109716579 | A | |
| | | | | KR | 10-2019-0141759 | A | |
| JP | 2012-115004 | A | 14 June 2012 | US | 2012/0130661 | A1 | |
| | | | | paragraphs [0159]-[0162], fig. 16 | | | |
| | | | | CN | 102540088 | A | |
| | | | | KR | 10-2012-0056200 | A | |
| JP | 09-017458 | A | 17 January 1997 | (Family: none) | | | |
| WO | 2022/063234 | A1 | 31 March 2022 | CN | 114280488 | A | |
| | | | | KR | 10-2023-0070506 | A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009254215 A